# EUROPEAN PATENT APPLICATION

(11) **EP 0 740 345 A2**
(43) Date of publication of application: **30.10.1996**
(21) Application number: 96106786.5
(22) Date of filing: 29.04.1996
(51) Int. Cl.: H01L 27/11

(54) **Semiconductor device having static memory cell provided with data retaining means**

(30) Priority: 27.04.1995 JP 103733/95
(71) Applicant: NEC CORPORATION, Tokyo (JP)
(72) Inventor: Yamada, Yasumasa, Nakahara-ku, Kawasaki-shi, Kanagawa (JP)
(74) Representative: Baronetzky, Klaus, Dipl.-Ing.

(57) **Abstract**

A semiconductor device has a memory cell which is constituted of a flip-flop circuit operating on power voltage between power supply lines 100 and 101. This memory cell further includes diodes 6 and 13, each of which is connected in series with a load of the flip-flop circuit between the power supply terminal 100 and each of input/output nodes of said flip-flop circuit.

## Description

### BACKGROUND OF THE INVENTION

### Field of the Invention

The present invention relates to a semiconductor device and, more particularly, to such a device that has a static memory cell for temporarily storing data.

### Description of the Related Art

A static memory cell is employes as a data holding element for a static random memory device (SRAM), a data register of a microcontroller and so on. Such a memory cell is generally constructed with a flip-flop in which two inverters are connected such that input and output nodes of one inverter are connected respectively to output and input nodes of the other inverter. Each of the inverters includes a insulated gate transistor such as a MOS transistor having a gate electrode connected to the input node and a drain-source current path connected between the output node and a first power supply line and a load element connected between the output node and a second power supply line. The load element is constituted of a resistor or an insulated gate transistor such as a MOS transistor as a thin film transistor (TFT).

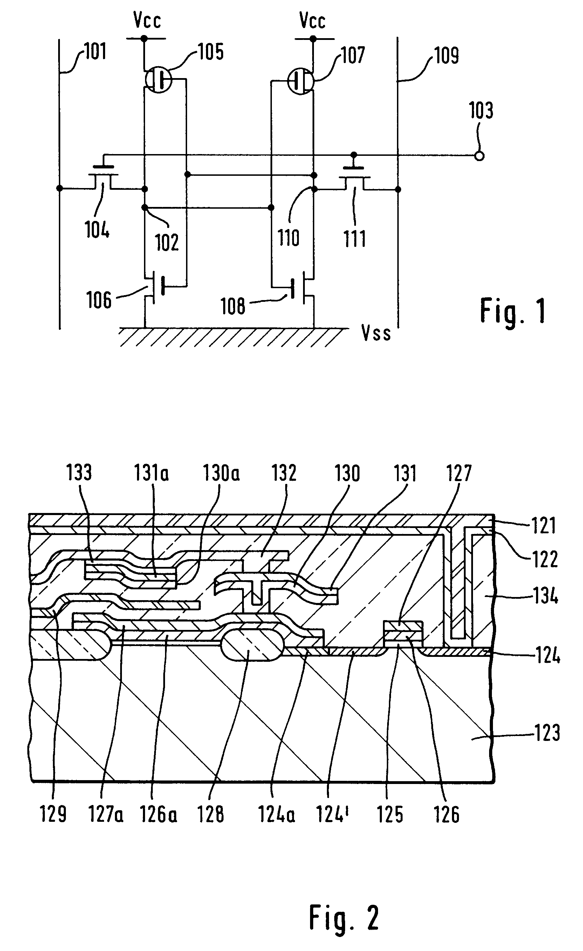

Referring now to Figs. 1 and 2, there is shown one memory cell employed in an SRAM. This SRAM cell includes a transfer transistor 104 between a bit line 101 and a contact 102 for forming a conductive path so as to supply voltage from the bit line 101 to the inside of the memory cell. The gate of the transfer transistor 101 is connected to a word line 103. The contact 102 is connected to the drains of a P-type thin film transistor 105 having a source connected to a power supply line Vcc and an N-type transistor 106 having a source connected to a GND line Vss. The contact 102 is further connected to the gates of a P-type thin film transistor 107 the source of which is connected to Vcc of the power supply, and of a drive transistor 108 the source of which is connected to Vss of GND. Moreover, a transfer transistor 111 is provided for forming a conductive path between a bit line 109 and a contact 110 to supply voltage from the bit line 109 to the inside of the memory cell. The gate of the transfer transistor 111 is connected to the word line 103. The contact 110 is connected to the gates of the P-type thin film transistor 107 the source of which is connected to the power supply, and of the N-type drive transistor 108 the source of which is connected to GND. In addition, the contact 110 is connected to the gates of the P-type thin film transistor 105 the source of which is connected to the power supply, and of the N-type drive transistor 106 the source of which is connected to GND. Thus, a flip-flop is constituted.

Now, the storing operation of the TFT type memory cell will be explained.

First, a case is assumed where the bit line 101 is at 'H' level, and the bit line 109 is at 'L' level. When the word line 103 turns to 'H' level, the transfer transistors 104 and 111 become conductive. 'H' level on the bit line 101 is decreased by the threshold voltage of the transfer transistor 104, and conducted to the contact 102 through the transfer transistor 104. Since the contact 102 is connected to the gates of the P-type thin film transistor 107 and the N-type drive transistor 108, the transistor 107 is turned to OFF state and the transistor 108 is turned to ON state so that the contact 110 becomes 'L' level. The thin film transistor 105 to the gate of which the contact 110 is connected is turned to ON state, and the transistor 106 is turned to OFF state so that the contact 110 becomes 'L' level. At the moment, even if the word line changes to 'L' level, the contact 102 continues to maintain 'H' level, the contact 110 continues to maintain 'L' level.

When the bit line 101 is 'L' level, and the bit line 109 is 'H' level, similar operation continues to maintain the contact 102 at 'L' level and the contact 110 at 'H' level.

In a device structure of this memory cell as shown in Fig. 2, an aluminum wi ring layer 121 and a titanium wiring layer 122 are coupled as one wiring layer to form a bit line 101 shown in FIG. 1. Moreover, the titanium wiring layer 122 is connected to an N-type diffusion layer 124 formed on a silicon substrate 123 with conductivity type of P. Here, as shown in FIG. 2, there is formed a MOS transistor having a source-drain region constituted by N-type diffusion layers 124 and 124', a gate electrode constituted by a gate insulation film 125, and a gate electrode constituted by a first polycrystal silicon layer 126 and a first silicide layer 127. This MOS transistor is a transfer transistor 104 shown in FIG. 1.

Then, an N-type diffusion layer 124a with low concentration is connected to the N-type diffusion layer 124'. In addition, the N-type diffusion layer 124a is connected to the first polycrystal silicon layer 126a doped with N-type impurities. To reduce resistance of the first polycrystal silicon layer 126a, the first silicide layer 127a which is mixture of silicon and metal with high melting point is provided on the first polycrystal silicon layer 126a. These two layers constitutes the gate electrode of the transistor 108 of FIG. 1.

Here, these drive transistors or transfer transistors are insulated and isolated each other by an element isolation/insulation film 128. Then, a tungsten layer 129 is formed to be the above-mentioned GND Vss wiring.

The above-mentioned first silicide layer 127a is connected to a second polycrystal silicon layer 130 provided thereon and doped with N-type impurities. In addition, the second polycrystal silicon layer 130 is connected to a second silicide layer 131. These two layers are connected to the P-type thin film transistor 107 shown in FIG. 1. Moreover, the second silicide layer 131 is connected to a third polycrystal silicon layer 132 provided thereon and doped with P-type impurities. This becomes a drain diffusion layer of the P-type thin film transistor 105 shown in FIG. 1. Here, an electrode constituted by a second polycrystal silicon layer 130a and a second silicide layer 131a becomes the gate electrode of the above-mentioned thin film transistor. Also, a gate insulation film 133 for the thin film transistor is formed by a silicon oxide film.

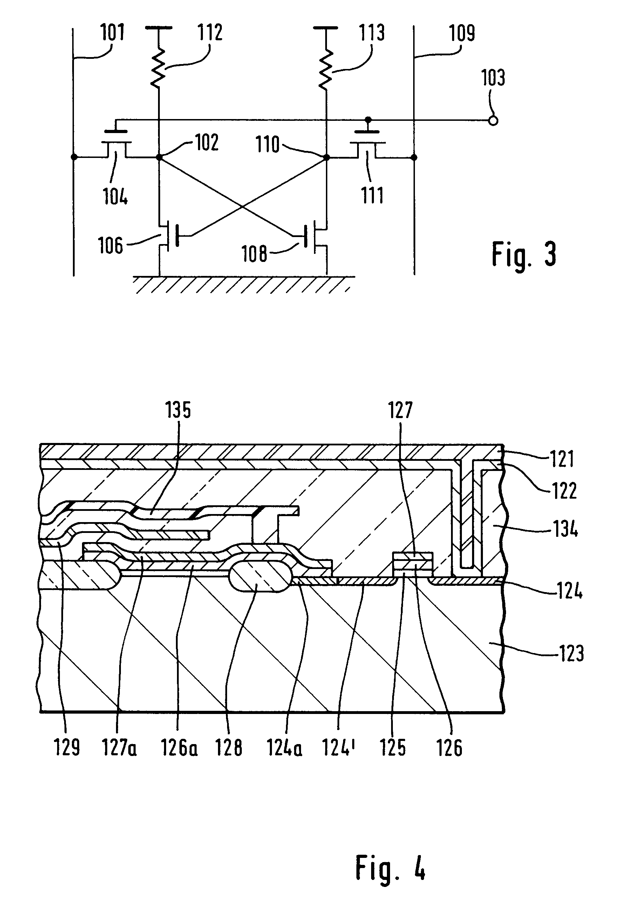

Turning to Figs. 3 and 4, there is shown another memory cell employed in an SRAM. In this cell, a transfer transistor 104 is provided between a bit line 101 and a contact 102 for forming a conductive path so as to supply voltage from the bit line 101 to the inside of the memory cell. The gate of the transfer transistor 104 is connected to a lead wire 103. The contact 102 is connected to a resistor 112 one end of which is connected to Vcc of the power supply and the drain of an N-type transistor 106 the source of which is connected to GND Vss. In addition, the contact 102 is connected to the gate of a transfer transistor 108 the source of which is connected to GND. Furthermore, a transfer transistor 111 is connected between a bit line 109 and a contact 110 for forming a conductive path so as to supply voltage from the bit line 109 to the inside of the memory cell. The gate of the transfer transistor 111 is connected to the lead wire 103. The contact 110 is connected to a resistor 113 one end of which is connected to the power supply and the drain of an N-type transistor 108 the source of which is connected to GND. The contact 110 is connected to the gate of an N-type transistor 106 the source of which is connected to GND. This equivalently constitutes a flip-flop.

Now, the storing operation of the resistance memory cell will be explained. A case is assumed where the bit line 101 is at 'H' level, and the bit line 109 is at 'L' level. When the word line 103 turns to 'H' level, the transfer transistors 104 and 111 are turned to ON state. Thus, 'H' level on the bit line 101 is connected to the contact 102 through the transfer transistor 104. Since the contact 102 is connected to the gate of the transistor 108, the transistor 108 is turned to ON state. The contact 110 becomes 'L' level because the amount of current which the transistor 108 causes to flow to GND is more than the amount of current flowing through the resistor 113. 'L' level is provided to the gate of the drive transistor 106 connected to the contact 110 so that the drive transistor 106 is turned to OFF state. Consequently, the contact 102 becomes 'H' level. At the moment, even if the word line 103 changes to 'L' level, the contact 102 continues to maintain 'H' level, the contact 110 continuous to maintain 'L' level.

In a case where the bit line 101 is at 'L' level, and the bit line 109 is at 'H' level, under a similar operation, the contact 102 maintains 'L' level, and the contact 110 maintains 'H' level.

In a device structure of the memory cell of Fig. 3, as shown in FIG. 4, an aluminum wiring layer 121 and a titanium wiring layer 122 are coupled as one wiring layer to form a bit line 101 shown in FIG. 3. Moreover, the titanium wiring layer 122 is connected to an N-type diffusion layer 124 formed on a P-type silicon substrate 123. Here, as described earlier, there is formed a MOS transistor having a source-drain region constituted by N-type diffusion layers 124 and 124', a gate electrode constituted by a gate insulation film 125, and a gate electrode constituted by a first polycrystal silicon layer 126 and a first silicide layer 127. Then, the N-type diffusion layer 124' is laterally connected to an N-type diffusion layer 124a with low concentration. It is further connected to a first polycrystal silicon layer 126a doped with N-type impurities. To reduce resistance of the first polycrystal silicon layer 126 a doped with N-type impurities, it is coupled to a first silicide layer 127a. This forms the wiring shown in FIG. 3, and connected to the gate electrode of the transistor 108 and the drain of the transistor 106. Then, there is provided a tungsten layer 129 serving as a GND Vss wiring. The first silicide layer 127a is connected to a high resistance layer 135. The high resistance layer 135 is formed from polycrystal silicon containing 20 - 30% of oxygen atoms.

In the memory cell as described above, when the voltage on the power supply line Vcc decreases, the voltage at the contact 102 (or 110) is also decreased in accordance therewith through the transistor 105 (or 107) or the resistor 112 (or 113). When the voltage at the contact 102 (or 110) is decreased up to such a level that is lower than the threshold level of the transistor 108 (or 106), the transistor 108 (or 106) is rendered non-conductive. The data stored in this memory cell is thus destroyed. In other words, the voltage on the power supply line Vcc decreased such a level that causes the transistor 108 (or 106) to be rendered non-conductive, the data stored in the memory cell is destroyed. The means that the data stored in the cell is destroyed even by a temporary change in voltage on the power supply line Vcc.

### SUMMARY OF THE INVENTION

It is, therefore, an object of the present invention to provide a semiconductor device including an improved memory cell.

Another object of the present invention is to provide a semiconductor device having a static memory cell provided with data retaining means for preventing data from being destroyed even under temporary lowering of a power supply voltage.

A semiconductor device according to the present invention comprises a supply terminal and an memory cell which has a flip-flop circuit, said memory cell includes an diode connected in a forward direction between said supply terminal and the input terminal of said flip-flop circuit to supply current from said supply terminal to said input terminal.

According to this arrangement, even if potential on the supply terminal is instantaneously broken, the diode performs rectifying operation to prevent the current from flowing from the input terminal to the supply terminal. Thus, no current path is produced from the input terminal of the flip-flop circuit to the supply terminal. Accordingly, the voltage at the input terminal does not change so that the information on the flip-flop circuit would be maintained.

### BRIEF DESCRIPTION OF THE DRAWINGS

The above and other objects, features and advantages of the present invention will be more apparent from the following description taken in conjunction with the accompanying drawings, in which:
FIG. 1 is a circuit diagram of a conventional TFT type memory cell;
FIG. 2 is the structure of the conventional TFT type memory cell;
FIG. 3 is a circuit diagram of a conventional high resistance memory cell;
FIG. 4 is the structure of the conventional high resistance memory cell;
FIG. 5 is a circuit diagram illustrating a first embodiment of the present invention;
FIG. 6 is the structure illustrating the first embodiment of the present invention;
FIG. 7 is a circuit diagram illustrating a second embodiment of the present invention; and
FIG. 8 is the structure illustrating the second embodiment of the present invention.

### DETAILED DESCRIPTION OF THE PREFERRED EMBODIMENTS

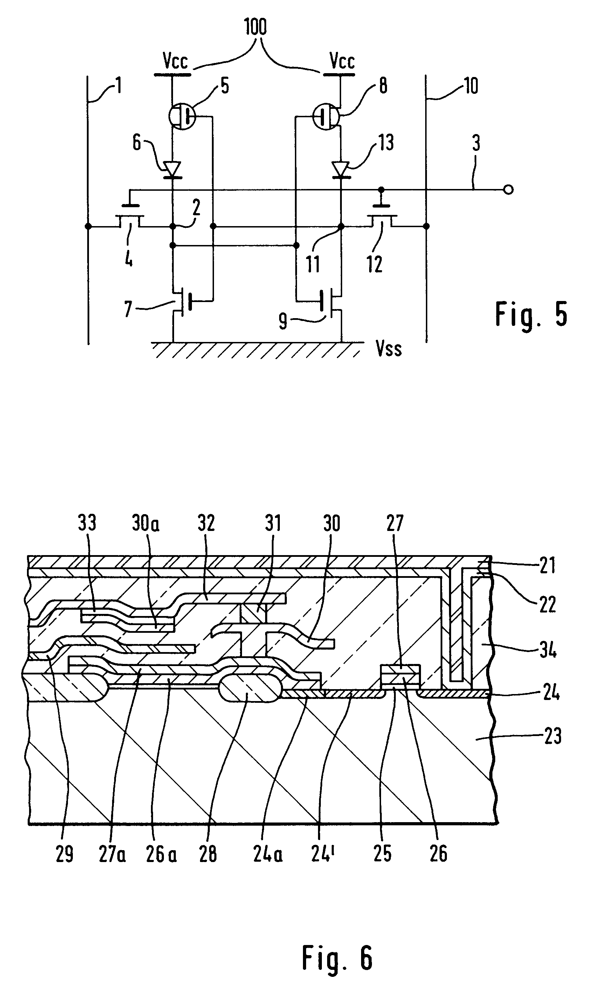

Referring now to Fig. 5, there is shown a memory cell employed in an SRAM as a first embodiment of the present invention. In this memory cell, an N-type transfer transistor 4 is provided between a bit line 1 and a contact 2 for supplying voltage form the bit line 1 to the inside of the memory cell so as to form a conductive path. The gate of the transfer transistor 4 is connected to a word line 3. Moreover, the drain of a P-type thin film transistor 5, the source of which is connected a supply terminal 100, is connected to the anode of a PN junction diode 6. The cathode of the PN junction diode 6 is connected to the contact 2. In addition, the contact 2 is connected to the drain of an N-type transistor 7, the source of which is connected to GND Vss, as well as to the gates of a P-type thin film transistor 8 the source of which is connected to the power supply, and of an N-type transistor the source of which is connected to GND. A transfer transistor 12 is provided between a bit line 10 and a node 11 for supplying voltage from the bit line 10 to the inside of the memory cell so as to form a conductive path. The gate of the transfer transistor 12 is connected to the word line 3. In addition, the drain of a P-type thin film transistor 8, the source of which is connected to a supply terminal 100, is connected to the anode of a PN junction diode 13. The cathode of the PN junction diode is connected to the node 11. In addition, the node 11 is connected to the drain of the transistor 9, as well as the gates of the thin film transistor 5 and of the transistor 7 to form a flip-flop.

The supply terminals 100 is applied with a voltage Vcc.

In FIG. 5, the diode 6 is connected between node 2 and the transistor 5, but it can also be used that the diode 6 is connected between the supply terminal 100 and the transistor 5. It can also be used that the diode 13 is connected between the supply terminal 100 and the transistor 8.

Now, the storing operation of the present invention will be explained. A case is assumed where the bit line 1 shown in FIG. 5 is at 'H' level, and a bit line 10 is at 'L' level. When the word line 3 becomes 'H' level, the transfer transistors 4 and 12 are turned to ON state so that 'H' level on the bit line 1 is reduced by the threshold voltage of the transfer transistor 4 through the transfer transistor 4 and supplied to the node 2. Since the node 2 is connected to the gates of the thin film transistor 8 and the transistor 9, the thin film transistor 8 is turned to OFF state, the transistor 9 is turned to ON state, and the node 11 becomes 'L' level. The thin film transistor 5, the gate of which the node 11 is connected, is turned to ON state. The transistor 7 is turned to OFF state so that current flows from the power supply to the node 2 through the thin film transistor 5 and the forward connected PN junction diode 6 so that the voltage at the node 2 is made the supply voltage Vcc. At the moment, even if the word line 3 changes to 'L' level, the nodes 2 and 11 maintain 'H' level and 'L' level, respectively. In addition, even if the supply voltage drops because of variation of the supply voltage Vcc, since current does not flow from the cathode to the anode of the PN junction diode 6 due to its characteristics, the node 2 can continue to maintain 'H' level. Thus, storage information is maintained.

In a case where the bit line 1 is at 'L' level, and the bit line 10 is at 'H' level, in a similar operation, the node 2 continues to maintain 'L' level, the contact 11 'H' level.

That is, since the PN junction diodes 6 and 13 are formed between the thin film transistors 5 and 8, which are the load transistors of the memory cell, and the drive transistors 7 and 9, respectively. The destruction of the storage information is prevented even if the supply Vcc is instantaneously broken.

Then, the device structure of the present invention is described with reference to FIG. 6. FIG. 6 is a sectional view of TFT type memory cell according to the present invention. Two layers of an aluminum wiring layer 21 and a titanium wiring layer 22 are coupled to form a bit line 1 shown in FIG. 1. Moreover, the titanium wiring layer 22 is connected to an N-type diffusion layer 24 formed on a P-type silicon substrate 23. Here, there is formed a MOS transistor having N-type diffusion layers 24 and 24' as its source-drain, a gate insulation film 25 as its gate electrode, and a first polycrystal silicon layer 26 and a first silicide layer 27 as its gate electrode. Then, the N-type diffusion layer 24' is laterally connected to an N-type diffusion layer 24a with low concentration. In addition, it is connected to a first polycrystal silicon layer 26a doped with N-type impurities. To reduce the resistance of the first polycrystal silicon layer 26a doped with N-type impurities, there is a first silicide layer 27a thereon, and these two layers are coupled. These two layers are connected to the gate electrode of the transistor 9 and the drain of the transistor 7. These transistors are insulated and isolated by an element isolation/insulation film 28. Furthermore, a tungsten layer 29 is formed serving as wiring for GND Vss.

The first silicide layer 27a is connected to a second polycrystal silicon layer 30 doped with N-type impurities. The second polycrystal silicon layer 30 connects to the gate electrode of the thin film transistor 8. In addition, the second polycrystal silicon layer 30 directly connects to a P-type silicon layer 31 doped with P-type impurities thus a PN junction diode is formed. The P-type silicon layer 31 is connected to a third polycrystal silicon layer 32. The second polycrystal silicon layer 30a becomes the gate electrode of the thin film transistor 5, and an insulation layer 33 becomes the gate insulation film of the thin film transistor 5. The third polycrystal silicon layer 32 is doped with N-type impurities for the source-drain region and P-type impurities for the channel region.

Then, the TFT type memory cell of the present invention is produced.

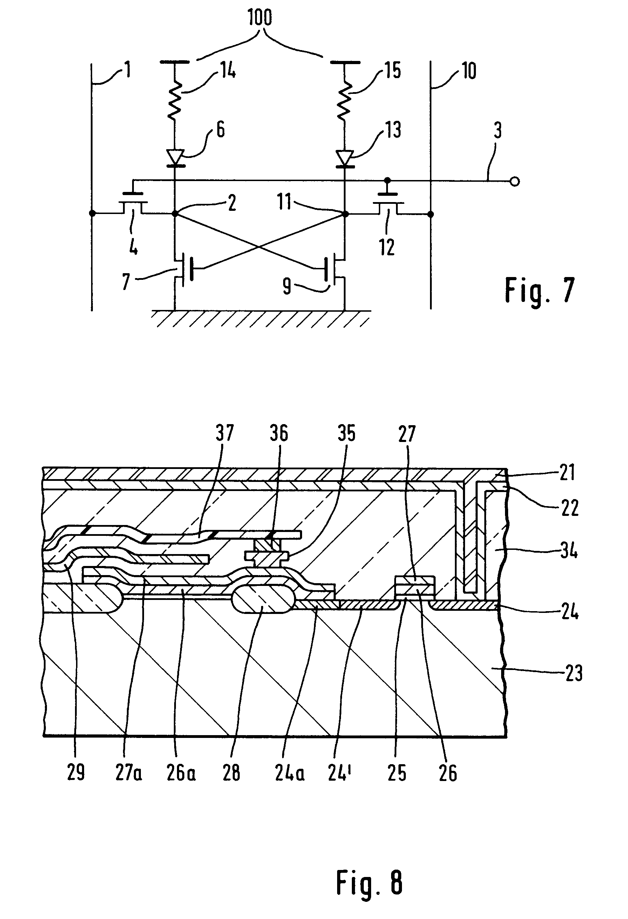

Next, as a second embodiment, a resistance memory cell will be explained based on FIGS. 7 and 8.

FIG. 7 is the circuit diagram of a resistance memory cell. A transfer transistor 4 is provided between a bit line 1 and a node 2 for supplying voltage from the bit line 1 to the inside of the memory cell so as to form a conductive path. The gate of the transfer transistor 4 is connected to a word line 3. One end of a resistor 14, the other end of which is connected to a supply terminal 100, is connected to the anode of a PN junction diode 6. The cathode of the PN junction diode 6 is connected to the node 2. In addition, the node 2 is connected to the gate of an N-type transistor 9 the source of which is connected to GND, and the drain of an N-type transistor 7 the source of which is connected to GND. In addition, a transfer transistor 12 is connected between a bit line 10 and a node 11 for supplying voltage from the bit line 10 to the inside of the memory cell so as to form a conductive path. The gate of the transfer transistor 12 is connected to the word line 3. An resistor 15 one end of which is connected to a supply terminal 100 is connected to the anode of a PN junction diode 13 with the other end. The cathode of the PN junction diode 13 is connected to the node 11. In addition, the node 11 is connected to the gate of the transistor 7 and the drain of the transistor 9 to equivalently form a flip-flop.

The supply terminal 100 is applied with the voltage Vcc.

In FIG. 7, the diode 6 is connected between node 2 and a resistor 14, but it can also be used that the diode 6 is connected between the supply terminal 100 and the resistor 14. It can also be used that diode 13 is connected between the supply terminal 100 and the resistor 15.

Now, the storing operation of the resistance memory cell according to the present invention will be explained by using FIG. 7. It is assumed that the bit line 1 is at 'H' level, and the bit line 10 is at 'L' level. When the word line 3 becomes 'H' level, the drive transistors 4 and 12 are turned to ON state, and 'H' level on the bit line 1 is transferred to the node 2 through the transistor 4. Since the node 2 is connected to the gate of the transistor 9, the transistor 9 is turned to ON state. At the moment, the node 11 becomes 'L' level. 'L' level is provided to the gate of the transistor 7 which is turned to OFF state, and the node 2 becomes 'H' level. At the moment, even if the word line 3 changes to 'L' level, the node 2 continues to maintain 'H' level, the contact 11 'L' level. In addition, similar to the first embodiment, even if the supply voltage Vcc varies, the node 2 continues to maintain 'H' level, the contact 11 'L' level.

When the bit line 1 is at 'L' level, and the bit line 10 is at 'H' level, in a similar operation, the node 2 continues to maintain 'L' level, the node 11 'H' level.

Then, the device structure of the resistance memory cell according to the present invention is described based on FIG. 8. FIG. 8 shows a sectional view of the resistance memory cell according to the present invention.

Similar to the first embodiment, two layers of an aluminum wiring layer 21 and a titanium wiring layer 22 are coupled as a bit line 1 shown in FIG. 7. Then, similar to the first embodiment, there is formed a MOS transistor having N-type diffusion layers 24 and 24' as its source-drain, and a gate electrode constituted by a gate insulation film 25, a first polycrystal silicon layer 26, and a first silicide layer 27. This transistor corresponds to the transfer transistor 4 in FIG. 7. In addition, the electrode constituted by a first polycrystal silicon layer 26a and a first silicide layer 27a which connects to an N-type diffusion layer 24a serves as the gate electrode of the transistor 9 shown in FIG. 7. Then, a tungsten layer 29 is formed. This layer is secured to the ground potential shown in FIG. 7.

After such arrangement is formed, an N-type silicon layer 35 and a P-type silicon layer 36 are formed. Then, a PN junction diode is formed at the junction of the N-type silicon layer 35 and the P-type silicon layer 36. This corresponds to the PN junction diode 6 shown in FIG. 7. Here, the N-type silicon layer 35 and the P-type silicon layer consist of a monocrystal or polycrystal silicon film the impurity concentration of which is determined in a similar manner to the first embodiment. Furthermore, a high resistance layer 37 is formed connecting the P-type silicon layer 36. The high resistance layer 37 consists of polycrystal silicon containing 20 - 30% oxygen atoms. This corresponds to the high resistance element 14 shown in FIG. 7.

As described in the above, according to the present invention, in an SRAM memory cell, a PN junction diode is connected in series between a contact at the drain of a P-type thin film transistor the contact at the source of which is connected to the power supply, and a contact at the drain of a drive transistor a contact at the source of which is connected to GND. Alternatively, a PN junction diode is connected in series between an end of a resistance the other end of which is connected to the power supply, and a contact of the drain of a transistor a contact at the source of which is connected to GND. Furthermore, a PN junction diode is connected in series between a supply line in a semiconductor chip, and a supply line which supplies the supply voltage to a memory cell group.

With such arrangements, data is prevented from being destroyed when the supply voltage drops or is instantaneously broken during operation of the SRAM. In addition, the present invention is very robust against variation of the supply voltage. For example, it can secure a longer data holding time by about 100-fold than that in the prior art. Thus, when it is used in a product the power supply of which relies on a dry cell or battery, while data in the memory cell will be destroyed in the prior art when the dry cell or battery is exchanged, the present invention can hold data for about ten seconds even if the supply is exhausted so that there is provided an advantage that a time for replacing the cell or battery can be obtained.

Furthermore, according to the present invention, the size of memory cell in an SRAM is not increased over the conventional memory cell. That is, the structure according to the present invention is suitable for higher integration or density so that improvement of capacity and quality of SRAM can be attained.

It is apparent that the present invention is not limited to the above embodiments but may be modified and changed without departing from the scope and spirit of the invention.

## Claims

1. A semiconductor device having at least one memory cell, said memory cell comprising a first inverter operating on a voltage between first and second power supply lines and having a first input node and a first output node, a second inverter operating on said voltage and a second input node coupled to said first output and a second output node coupled to said first input node, and means for suppressing lowering in voltage at each of said first and second output nodes against lowering of said voltage between said first and second power supply lines.

2. The device as claimed in claim 1, wherein each of said first and second inverters includes a load element coupled between an associated one of said first and second output nodes and said first power supply line and said means comprises a diode connected in series with said load element between said associated one of said first and second output nodes and said first power supply line.

3. The device as claimed in claim 2, wherein said diodes is constituted of a first poly-silicon layer of a first conductivity type and a second poly-silicon layer of a second conductivity type.

4. A semiconductor device comprising a first inverter, a second inverted coupled to said first inverter to form a flip-flop circuit, each of said first and second inverters including a switching transistor and a load element connected in series between first and second power supply lines, and first and second unidirectional elements each coupled in series to said load element of an associated one of said first and second inverters between said switching transistor of said associated one of said first and second inverters and said first power supply line.

5. The device as claimed in claim 4, wherein each of said first and second unidirectional elements in a diode.

6. The device as claimed in claim 5, wherein said diode has an anode connected to said load element and a cathode connected to said switching transistor.

7. A semiconductor device comprising a supply terminal and an memory cell which has a flip-flop circuit, said memory cell including an diode connected in a forward direction between said supply terminal and the input terminal of said flip-flop circuit to supply current from said supply terminal to said input terminal.
